# EUROPÄISCHE PATENTANMELDUNG

(11) **EP 2 066 034 A2**
(43) Veröffentlichungstag der Anmeldung: **03.06.2009**
(21) Anmeldenummer: 08020675.8
(22) Anmeldetag: 28.11.2008
(51) Int. Cl.: H03K 17/955

(54) **Einklemmsensor**

(30) Priorität: 30.11.2007 DE 202007016734 U
(71) Anmelder: Brose Fahrzeugteile Gmbh&Co.Kg, Hallstadt, 96103 Hallstadt (DE)
(72) Erfinder: Würstlein, Holger, 97475 Zeil am Main (DE); Weingärtner, Thomas, 96117 Memmelsdorf (DE)
(74) Vertreter: Stammler, Wolfgang

(57) **Zusammenfassung**

Einklemmsensor (2,2',2"), insbesondere zum Erkennen eines Hindernisses im Weg eines Stellelements eines Kraftfahrzeugs, mit einer ersten Messelektrode (6) und mit einer von der ersten Messelektrode (6) beabstandeten, elektrisch getrennten zweiten Messelektrode (7), wobei die erste Messelektrode (6) zur Erzeugung eines äußeren elektrischen Felds (17) gegenüber der zweiten Messelektrode (6) ausgebildet ist, und wobei die erste und zweite Messelektrode (5,6) gegenüber einer elektrisch getrennten Grundelektrode (8) elastisch gelagert sind. Weiter wird eine Sensoreinrichtung (1) mit einem derartigen Einklemmsensor (2, 2', 2") angegeben. Der Einklemmsensor (2, 2', 2") eignet sich sowohl als ein berührungsloser als auch ein taktiler Sensor. Ein Erkennen einer oberflächlichen Ablagerung von Schmutz oder Wasser ist leicht möglich.

## Beschreibung

Die Erfindung betrifft einen Einklemmsensor, insbesondere zum Erkennen eines Hindernisses im Weg eines Stellelements eines Kraffahrzeugs, mit einer ersten Messelektrode und mit einer von der ersten Messelektrode beabstandeten, elektrisch getrennten zweiten Messelektrode, wobei die erste Messelektrode zur Erzeugung eines äußeren elektrischen Felds gegenüber der zweiten Messelektrode ausgebildet ist. Die Erfindung betrifft weiter eine Sensoreinrichtung mit einem derartigen Einklemmsensor, wobei eine Messelektronik zur Auswertung der Messkapazität zwischen den Messelektroden vorgesehen ist.

Ein Einklemmsensor der vorgenannten Art nutzt zum Erkennen eines Hindernisses das kapazitive Messprinzip. Hierzu wird mittels der beiden Messelektroden ein äußeres elektrisches Feld aufgebaut. Tritt in dieses elektrische Feld ein Dielektrikum ein, so verändert sich die Kapazität des von den Messelektroden gebildeten Kondensators. Auf diese Weise kann theoretisch ein Hindernis im Weg eines Stellelements eines Kraftfahrzeugs detektiert werden, sofern sich dessen relative Dielektrizitätszahl εᵣ von der relativen Dielektrizitätszahl von Luft unterscheidet. Auch wird eine Änderung der Kapazität bei einem Masseschluss des eindringenden Hindernisses hervorgerufen, da sich hierdurch die Ladungsverteilung auf den Messelektroden verändert.

Das Hindernis im Weg eines Stellelements wird ohne einen physischen Kontakt mit dem Einklemmsensor erkannt. Mit anderen Worten handelt es sich um einen sogenannten berührungslosen Sensor. Wird eine Kapazitätsänderung detektiert, so können rechtzeitig Gegenmaßnahmen, wie beispielsweise ein Stoppen oder ein Reversieren des Antriebs eingeleitet werden, bevor es zu einem tatsächlichen Einklemmen des Hindernisses kommt. Bei den Stellelementen eines Kraftfahrzeuges kann es sich beispielsweise um ein elektrisch betätigbares Fenster, eine elektrisch betätigbare Schiebetür oder eine elektrisch betätigbare Heckklappe handeln. Auch kann ein auf dem kapazitiven Messprinzip beruhender Einklemmsensor zur Detektion von Hindernissen im Falle eines elektrisch betätigbaren Sitzes eingesetzt werden.

Ein Einklemmsensor der eingangs genannten Art ist beispielsweise aus der US 6, 972,575 B2 bekannt. Zwischen den beiden Messelektroden ist dort eine Grundelektrode angeordnet, die auf der direkten Verbindungslinie zwischen den Messelektroden eine Abschirmung bewirkt. Auf diese Weise wird die Sensitivität des Einklemmsensors gegenüber von Hindernissen im äußeren elektrischen Feld erhöht.

Auch aus der EP 1 455 044 A2 ist ein Einklemmsensor der eingangs genannten Art bekannt, wobei zusätzlich zu einer Kapazitätserfassung zwischen den beiden Messelektroden deren elektrische Kontaktierung bei einer äußeren Krafteinwirkung registriert wird. Für diese Doppelfunktion als ein berührungsloser und zugleich taktiler Sensor sind die Messelektroden in einen elastomeren Werkstoff eingebettet und zueinander über eine Hohlkammer beabstandet.

Des Weiteren wird in der EP 1 154 110 A2 ein Einklemmsensor der eingangs genannten Art vorbeschrieben, wobei die das äußere elektrische Feld aufbauenden Messelektroden zueinander beweglich ausgestaltet sind. Dies wird beispielsweise durch einen Hohlraum oder mittels eines elastischen Materials verwirklicht. Über die Erfassung einer Änderung der Kapazität des durch die Messelektroden gebildeten Kondensators wird ein Hindernis sowohl berührungslos bei seiner Annäherung als auch durch direkten Kontakt mit dem Sensor, wobei sich der Abstand der Messelektroden zueinander verändert, erfasst.

Aufgabe der Erfindung ist es, einen verbesserten, nach dem kapazitiven Messprinzip arbeitenden Einklemmsensor der eingangs genannten Art anzugeben, der sich sowohl für eine berührungslose als auch eine taktile Erfassung von Hindernissen eignet.

Diese Aufgabe wird erfindungsgemäß gelöst durch einen Einklemmsensor mit der Merkmalskombination gemäß Anspruch 1. Demnach ist ein Einklemmsensor vorgesehen, der eine erste Messelektrode und eine von der ersten Messelektrode beabstandete, elektrisch getrennte zweite Messelektrode umfasst, wobei die erste Messelektrode zur Erzeugung eines äußeren elektrischen Felds gegenüber der zweiten Messelektrode ausgebildet ist, und wobei die erste und die zweite Messelektrode gegenüber einer elektrisch getrennten Grundelektrode elastisch gelagert sind.

Die Erfindung geht dabei von der Überlegung aus, nicht jeweils eine Kapazität zwischen den Messelektroden und der Grundelektrode, sondern eine differenzielle Kapazität zwischen den beiden Messelektroden zu erfassen. Die differenzielle Kapazität wird nämlich sowohl durch die Annäherung eines äußeren Hindernisses in das durch die beiden Messelektroden gebildete äußere elektrische Feld als auch durch eine Positionsänderung der Grundelektrode beeinflusst. Denn wie bei einem Eindringen eines Hindernisses mit Masseschluss in das äußere elektrische Feld wird die Ladungsverteilung auf den Messelektroden auch durch eine Positionsänderung der auf einem Grundpotenzial wie Masse liegenden Grundelektrode gegenüber den Messelektroden beeinflusst.

Insofern eignet sich der angegebene Einklemmsensor alleine durch das Vorsehen einer elastischen Lagerung der Messelektroden gegenüber der Grundelektrode zugleich als berührungsloser und als taktiler Sensor. Dabei sind beide Messprinzipen durch die Erfassung der differenziellen Kapazität zwischen den Messelektroden verwirklicht.

Bei einem herkömmlichen kapazitiven Sensor führt eine oberflächliche Verschmutzung zu Messartefakten, die irrtümlich als ein Einklemmfall interpretiert werden können. Der angegebene Einklemmsensor bietet zusätzlich den großen Vorteil der Möglichkeit einer einfachen Kompensation derartiger Messartefakte.

Eine Verschmutzung oder ein Wasserfilm auf der in der Regel in den Gefährdungsbereich gerichteten Oberfläche des Einklemmsensors wirkt hinsichtlich der differenziellen Kapazität zwischen den Messelektroden wie das Einbringen eines Dielektrikums in einen Kondensator. Da Verschmutzungen und Wasser eine relative Dielektrizitätszahl größer als Luft aufweisen, wird sich bei einer oberflächlichen Verschmutzung oder Wasserbeaufschlagung die Kapazität zwischen den Messelektroden vergrößern.

Durch umfangreiche Untersuchungen hat sich aber gezeigt, dass ein in das äußere Feld eindringendes Hindernis mit Masseschluss, wie beispielsweise eine menschliche Hand, die über die Hautoberfläche einen Masseschluss aufweist, zunächst durch die geänderte Ladungsverteilung zu einer Verringerung der Kapazität führt. Erst bei weiterer Annäherung wirkt sich gegebenenfalls die gegenüber Luft erhöhte relative Dielektrizitätszahl des Hindernisses aus, und kann im Nahfeld wieder zu einem Anstieg der Messkapazität führen.

Der angegebene Einklemmsensor ist somit in der Lage, zwischen einem im Gefährdungsbereich eindringenden Hindernis und einer oberflächlichen Beaufschlagung mit Schmutz oder Wasser zu unterscheiden. Eine Erhöhung der Messkapazität kann somit einer Oberflächenbeaufschlagung zugeordnet und eine Verringerung der Messkapazität, insbesondere bei einer Bewegung des Stellelements, als ein Einklemmfall interpretiert werden.

Schließlich wird bei weiterer Annäherung des Einklemmsensors an das Hindernis ein direkter Kontakt des Einklemmsensors mit dem Hindernis stattfinden. Aufgrund der elastischen Lagerung der Messelektroden gegenüber der Grundelektrode führt die aus dem direkten physischen Kontakt resultierende Krafteinwirkung dabei zu einer Annäherung der Grundelektrode gegenüber den Messelektroden. Durch diese Annäherung der auf Grundpotenzial liegenden Grundelektrode wird die Kopplung zwischen den Messelektroden verringert, so dass auch in diesem Fall die Messkapazität abnimmt.

Zu einer Detektion der differenziellen Messkapazität wird beispielsweise die erste Messelektrode mittels eines geeigneten Spannungsgenerators gegenüber dem Grundpotenzial wie Masse mit einer Wechselspannung beaufschlagt. Die zweite Messelektrode wird über eine Impedanz mit dem Grundpotenzial verbunden. Auf diese Weise kann die Messkapazität zwischen den beiden Messelektroden beispielsweise über eine zwischen der zweiten Messelektrode und dem Grundpotenzial eingeschaltete Messbrücke (mittels der Impedanz) als eine Phasen- oder als eine Amplitudeninformation eines Spannungswertes abgegriffen werden.

Grundsätzlich ist die Erfindung nicht auf eine spezifische Anordnung der Messelektroden gegenüber der Grundelektrode festgelegt. So können die Messelektroden gegenüber der Grundelektrode beliebig im Einklemmsensor positioniert sein. Denn jedwede Lageänderung der Messelektroden gegenüber der Grundelektrode wird zu einer geänderten Ladungsverteilung und somit zu einer geänderten Messkapazität führen.

Aus praktischen Gründen bietet es sich jedoch an, die erste und die zweite Messelektrode auf einer ersten Ebene anzuordnen, die von einer zweiten Ebene, in der die Grundelektrode angeordnet ist, beabstandet ist. Auf diese Weise kann insbesondere ein baulich flacher Einklemmsensor verwirklicht werden, der beispielsweise leicht entlang der Schließkante eines beweglichen Stellelements geführt werden kann. Andererseits ist es ebenso möglich, die Positionierung der Messelektroden gegenüber der Grundelektrode den baulichen Gegebenheiten, insbesondere eines Kraftfahrzeugs, anzupassen.

Für den Einklemmsensor ist es weiter nicht notwendigerweise erforderlich, die Grundelektrode als ein Sensorbestandteil auszuführen. Insbesondere kann der Einklemmsensor lediglich mit den beiden Messelektroden ausgerüstet sein und der mit Masse verbundenen Karosserie eines Kraftfahrzeugs aufgelegt werden. In diesem Fall bildet die Karosserie als solche die Grundelektrode. Bei dieser Ausgestaltung wird es lediglich erforderlich, zwischen den Messelektroden und der dann als Grundelektrode wirkenden Karosserie dem Sensorkörper eine Zwischenlage zuzuordnen, über die die Messelektroden gegenüber der Karosserie elastisch beabstandet sind.

Vorteilhafterweise ist jedoch die Grundelektrode selbst ein Sensorbestandteil und hierzu in den Sensorkörper eingebettet. Dabei kann die elastische Lagerung sowohl durch die vorgenannte Zwischenlage aus einem elastischen Material verwirklicht sein, über welche die Messelektroden von der Grundelektrode beabstandet sind. Alternativ ist es aber auch möglich, die Grundelektrode und die Messelektroden in ein elastisches Material einzubetten, wobei die Messelektroden gegenüber der Grundelektrode durch eine Hohlkammer getrennt sind. In beiden zueinander komplementären Ausgestaltungen wird die Einwirkung einer äußeren Kraft auf den Sensorkörper zu einer Annäherung der Messelektroden an die Grundelektrode führen.

In einer weiter bevorzugten Ausgestaltung sind die Messelektroden jeweils in einem Randbereich des Einklemmsensors angeordnet. Hierdurch wird die Messkapazität auf Grund des größeren Abstandes der Messelektroden zueinander verringert. Dadurch werden in Relation die durch ein Hindernis hervorgerufenen Änderungen der Messkapazität vergrößert. Insofern wird durch diese Maßnahme die Empfindlichkeit des Einklemmsensors verbessert. Darüber hinaus kann durch die Anordnung der Messelektrode in einem Randbereich des Einklemmsensors die Reichweite des äußeren elektrischen Feldes vergrößert werden.

Auch auf die Form der Elektroden selbst ist der vorbeschriebene Einklemmsensor nicht festgelegt. Zweckmäßigerweise sind die Elektroden jedoch jeweils flächig ausgebildet, was wiederum eine flache Ausgestaltung des Einklemmsensors ermöglicht. Auch ist über eine solche flächige Ausgestaltung der Elektroden eine gute Ausrichtung des äußeren elektrischen Feldes möglich und es lässt sich wiederum eine hohe Reichweite erzielen.

Bei einer flächigen Ausgestaltung der Elektroden ist es weiter vorteilhaft, wenn die Fläche der Grundelektrode in Projektion die Flächen der weiteren Messelektroden überstreicht. Hierdurch ist bei einem einfachen Grundaufbau des Einklemmsensors eine möglichst große Änderung der Messkapazität bei Annäherung der Grundelektroden an die Messelektroden gewährleistet.

In einer bevorzugten weiteren Ausgestaltung des Einklemmsensors ist eine dritte, von der ersten und der zweiten Messelektrode elektrisch getrennte Messelektrode vorgesehen, die zur zweiten Messelektrode benachbart ist, wobei die Messelektroden zu Ausbildung eines ersten äußeren elektrischen Feldes zwischen der ersten und der zweiten Messelektrode und eines zweiten äußeren elektrischen Feldes zwischen der ersten und der dritten Messelektrode ausgebildet sind, und wobei das zweite äußere elektrische Feld eine geringere Reichweite aufweist als das erste elektrische Feld.

Bei einem derartigen Einklemmsensor können Unterschiede der festgestellten Änderungen der den beiden äußeren Feldern zugeordneten Kapazitäten zum Erkennen einer oberflächlichen Beaufschlagung des Sensorkörpers mit Schmutz oder Wasser herangezogen werden.

Befindet sich Schmutz oder Wasser als Ablagerung bzw. als Benetzung auf der Oberfläche des Einklemmsensors, so bewirkt dies eine Änderung der Kapazität sowohl des Kondensators aus erster und zweiter Messelektrode als auch des Kondensators aus erster und dritter Messelektrode. Es handelt sich um eine Nahfeldbeeinflussung auf beide Kapazitäten. Ein sich aus dem Fernfeld annäherndes Hindernis bewirkt hingegen hauptsächlich eine Änderung der Kapazität desjenigen Kondensators, der ein weiter in den Gefährdungsbereichen hineinragendes äußeres elektrisches Feld ausbildet. Vorliegend ist dies die Kapazität des aus erster und zweiter Messelektrode gebildeten Kondensators. Während das Nahfeld durch das in den Gefährdungsbereich eindringende Hindernis noch nicht berührt und somit noch keine Kapazitätsänderung detektierbar ist, wird das Hindernis über das elektrische Feld größerer Reichweite bereits erfasst, bzw. als Kapazitätsänderung detektierbar.

Ein derart ausgebildeter Einklemmsensor erlaubt es demnach, eine Schmutzablagerung oder eine Wasserbenetzung auf der Oberfläche des Sensors als ein Gleichsignal und ein sich näherndes Hindernis als ein Differenzsignal zu erfassen und insofern zu unterscheiden.

Die unterschiedliche Reichweite der mittels der Messelektroden erzeugten elektrischen Felder kann dabei durch die Geometrie und/oder Dimensionierung der jeweiligen Messanordnungen beeinflusst bzw. erzielt werden. So kann beispielsweise die dritte Messelektrode zur Erzielung eines möglichst kurzreichweitigen elektrischen Feldes derart ausgestaltet sein, dass die Feldlinien einen möglichst direkten Verlauf zwischen der dritten und der ersten Messelektrode aufweisen. Auf der anderen Seite kann die zweite Messelektrode derart ausgestaltet, angeordnet oder dimensioniert sein, dass die Feldlinien des erzeugten elektrischen Feldes gegenüber der ersten Messelektrode nach Art eines Streufeldkondensators einen möglichst langen Umweg durch den Gefährdungsbereich des Stellelements nehmen. Insbesondere kann die dritte Messelektrode der ersten Messelektrode unmittelbar benachbart angeordnet sein, wohingegen die zweite Messelektrode von der Gegenelektrode beabstandet ist.

Eine weitere sinnvolle Ausgestaltung ist dadurch gegeben, dass die zweite Messelektrode sich in einem Randbereich des Einklemmsensors befindet, und die dritte Messelektrode zwischen der ersten und der zweiten Messelektrode angeordnet ist. Hierdurch ist bei einer flachen Ausgestaltung und einfacher Bauweise gewährleistet, dass das zweite äußere elektrische Feld eine geringere Reichweite aufweist als das erste äußere elektrische Feld. Bei einer flächigen Ausgestaltung der Messelektroden kann über die Größe der Fläche die Kapazität der jeweils gebildeten Kondensatoren in bekannter Weise ermittelt bzw. angepasst werden. Somit ist es möglich, über die Flächenverhältnisse der Messelektroden zueinander das Verhältnis der aus erster und zweiter bzw. aus erster und dritter Messelektrode gebildeten Kapazitäten einzustellen. Insbesondere kann die Reichweite des sich in den Gefährdungsbereich hinein erstreckenden ersten äußeren elektrischen Feldes durch eine Vergrößerung der Fläche der zweiten Messelektrode erhöht werden.

Über eine geeignete Dimensionierung der Messelektrodenflächen kann insbesondere erreicht werden, dass ein in unmittelbarer Nähe in beide äußere elektrische Felder eingebrachtes Dielektrikum keine Drift der Messkapazitäten zueinander verursacht. Mit anderen Worten ist die Dimensionierung derart gewählt, dass eine Ablagerung von Schmutz oder Wasser auf der Oberfläche des Sensors zu einer etwa gleichen Änderung der Kapazitäten der die zweite bzw. die dritte Messelektrode umfassenden Kondensatoren führt. Ein aus den Kapazitäten der beiden Kondensatoren gebildetes Differenzsignal erfährt folglich durch eine Verschmutzung oder durch eine Wasserbenetzung der Oberfläche des Sensors im Wesentlichen keine oder nur eine vernachlässigbare Änderung.

In einer zweckmäßigen Ausgestaltung sind die Elektroden und die Zwischenlage in einem Sensorkörper aus einem flexiblen Trägermaterial angeordnet. Dies erlaubt es, den Einklemmsensor leicht entlang der Kontur einer Schließkante eines Kraftfahrzeugs zu führen. Insbesondere kann der Sensorkörper als ein flexibles Flachbandkabel ausgeformt sein. Ebenso gut ist es vorstellbar, den Sensorkörper als einen Dichtkörper auszugestalten oder den Sensorkörper in einen Dichtkörper zu integrieren. Der Dichtkörper ist dabei dafür vorgesehen, das Stellelement gegenüber der Schließkante im geschlossenen Zustand abzudichten. Als Beispiel hierfür kann eine Dichtlippe erwähnt werden, die eine betätigbare Seitenscheibe eines Kraftfahrzeugs gegenüber ihrer Schließkante abdichtet.

Ein flexibles Flachbandkabel wird auch als FFC ("Flexible Flat Cable") bezeichnet, und zeichnet sich dadurch aus, dass in einem flexiblen Kabelkörper parallele Leiterstrukturen verlegt sind. Alternativ zu einem FFC kann als Sensorkörper auch eine flexible Leiterstruktur verwendet werden. Eine flexible Leiterstruktur ist auch unter dem Begriff FPC ("Flexible Printed Circuit") bekannt. Dabei sind in einem flexiblen Isoliermaterial, insbesondere in mehrschichtiger Anordnung, Leiterbahnen spezifisch angeordnet oder verlegt. Eine solche Ausgestaltung erlaubt eine hohe Flexibilität hinsichtlich der Dimensionierung und Anordnung der einzelnen Leiterbahnen, so dass die Messelelektroden des Einklemmsensors in gewünschter Art und Weise angeordnet oder dimensioniert werden können.

In einer weiteren vorteilhaften Ausgestaltung erstreckt sich der Sensorkörper im Wesentlichen entlang einer Längsrichtung, wobei in einer zweckmäßigen Ausgestaltung die erste Messelektrode entlang der Längsrichtung in einzeln ansteuerbare Einzelelektroden unterteilt ist. Hierdurch wird erreicht, dass sich die jeweils zwischen den Messelektroden messbare Kapazität verringert, da die gesamte Fläche der Messelektroden in mehrere unterbrochene Einzelflächen der getrennten Einzelelektroden aufgeteilt ist. Eine niedrige, sich insgesamt zwischen den Messelektroden ausbildende Kapazität führt jedoch dazu, dass sich eine kleine Kapazitätsänderung im Verhältnis zur gesamten Messkapazität leichter detektieren lässt. Ein derart ausgestalteter Einklemmsensor erlaubt zudem die Detektion einer Kapazitätsänderung mittels eines Multiplex-Verfahrens. Dabei können die einzelnen Elektroden mittels separater Zuleitungen entweder zeitlich versetzt (seriell) oder gleichzeitig (parallel) angesteuert werden. Insofern ist auch eine örtliche Auflösung eines Einklemmfalls ermöglicht. Eine Segmentierung alleine der als Sendeelektrode wirkenden ersten Messelektrode hat dabei den Vorteil, dass eine örtliche und/oder zeitliche Ansteuerung möglich ist, wobei aber nur eine Auswertung, nämlich der nicht segmentierten weiteren Elektroden, vorzusehen ist bzw. durchgeführt werden muss. In einer weiter bevorzugten Variante sind jedoch alle Messelektroden in Einzelelektroden unterteilt.

Bei der soeben beschriebenen Ausgestaltung bietet es sich insbesondere an, die Zuleitungen zu den Einzelelektroden durch die Grundelektrode abzuschirmen. Hierdurch werden direkte Kapazitäten der Zuleitungen vermieden.

Zur Abschirmung ist es weiter vorteilhaft, eine zweite Grundelektrode als Sensorbestandteil vorzusehen, wobei die Zuleitungen zur Abschirmung zwischen beiden Grundelektroden angeordnet sind. Durch eine solche Anordnung werden direkte Kapazitäten der Zuleitungen sowohl mit äußeren, sich auf einem anderen Potenzial befindlichen Flächen als auch gegenüber den Einzelelektroden vermieden.

Eine weitere Aufgabe der Erfindung ist es, eine gegenüber dem Stand der Technik verbesserte Sensoreinrichtung anzugeben, mit der sowohl bei einer direkten Berührung als auch berührungslos ein Einklemmfall detektierbar ist.

Diese Aufgabe wird erfindungsgemäß gelöst durch eine Sensoreinrichtung mit einem Einklemmsensor der vorbeschriebenden Art, wobei eine Messelektonik zur Detektion einer Messkapazität zwischen der ersten und der zweiten Messelektrode vorgesehen ist.

Vorteilhafte Ausgestaltungen können den auf die Sensoreinrichtung gerichteten Unteransprüchen entnommen werden. Dabei sind die für den Einklemmsensor genannten Vorteile sinngemäß auch auf die Sensoreinrichtung zu übertragen.

In einer bevorzugten Ausgestaltung ist die Messelektronik dafür ausgelegt, eine sich gegenüber einer Grundkapazität verringernde Messkapazität als einen Einklemmfall zu identifizieren. Wie bereits ausgeführt, führt ein in den erfassten Gefährdungsbereich eindringendes Hindernis mit Masseschluss zu einer Verringerung der Messkapazität. Ebenso verringert sich die Messkapazität bei einer Annäherung der Grundelektrode an die Messelektroden durch einen direkten Kontakt des Sensors mit einem Hindernis. Insofern ist eine sich verringernde Messkapazität ein Indiz für das Vorliegen eines Einklemmfalles.

Weiter ist es vorteilhaft, wenn die Messelektronik dafür ausgelegt ist, eine sich gegenüber einer Grundkapazität vergrößernde Messkapazität als eine oberflächliche Verschmutzung oder Wasserbeaufschlagung des Sensors zu identifizieren. Wie ausgeführt, wirkt nämlich eine solche Beaufschlagung wie das Einbringen eines Dielektrikums mit einer größeren relativen Dielektrizitätzahl in den Kondensator zwischen der ersten und der zweiten Messelektrode.

Ein bereits in den Gefährdungsbereich eingedrungenes Hindernis könnte nun im Nahbereich ebenfalls auf Grund der höheren relativen Dielektrizitätszahl zu einer Vergrößerung der Messkapazität führen. Einer solchen durch ein Hindernis im Nahfeld hervorgerufenen Vergrößerung der Messkapazität ist jedoch bereits eine Verringerung der Messkapazität beim Eindringen des Hindernisses aus der Ferne vorausgegangen. Wird demnach der zeitliche Verlauf der Änderung der Messkapazität erfasst, so ist es möglich, einen Einklemmfall sicher von einem durch eine Beaufschlagung der Oberfläche resultierenden Messartefakt zu unterscheiden.

Bei der Ausgestaltung des Einklemmsensors mit drei Messelektroden, wobei zwischen der ersten und der dritten Messelektrode ein äußeres elektrisches Feld geringerer Reichweite aufgebaut wird als zwischen der ersten und der zweiten Messelektrode, ist die Messelektronik vorteilhafterweise zu einer Erfassung einer Drift der Kapazität zwischen der ersten und der zweiten Messelektrode gegenüber einer Kapazität zwischen der ersten und der dritten Messelektrode ausgelegt.

Wie vorbeschrieben, führt nämlich eine oberflächliche Ablagerung von Schmutz oder Wasser zu einer gleichen Änderung der beiden Messkapazitäten, wohingegen ein aus dem Fernfeld eindringendes Hindernis zunächst nur die Messkapazität zwischen der ersten und der zweiten Messelektrode beeinflusst. Durch Beobachtung der Drift der Messkapazitäten zueinander kann insofern ein Einklemmfall klar gegenüber einem durch eine oberflächliche Verschmutzung oder Wasser hervorgerufen Messartefakt unterscheiden werden.

Bei einer zweckmäßigen Ausgestaltung der Sensoreinrichtung, wobei die Messelektroden des Enklemmsensors in einzeln ansteuerbare Einzelelektroden unterteilt sind, ist die Messelektronik bevorzugt dafür ausgelegt, die Einzelelektroden separat anzusteuern und deren Messkapazitäten einzeln auszuwerten. Hierdurch wird eine räumliche Auflösung der erfassten Einklemmfälle ermöglicht.

Ausführungsbeispiele der Erfindung werden anhand einer Zeichnung näher erläutert. Dabei zeigen:
- Fig.1: schematisch eine Sensoreinrichtung mit einem Einklemmsensor und einer Messeinrichtung,
- Fig.2: in einem Querschnitt den Einklemmsensor gemäß Fig. 1 mit zwei gegenüber einer Grundelektrode beanstandenden Messelektroden,
- Fig. 3: in einem Querschnitt einen weiteren Einklemmsensor, wobei die Messelektroden in Einzelelektroden unterteilt und mittels geschirmter Zuleitungen kontaktiert sind,
- Fig. 4: in einem Querschnitt einen weiteren Einklemmsensor mit drei Messelektroden und einer Grundelektrode,
- Fig. 5: in einem Querschnitt den Einklemmsensor gemäß Fig. 2 mit einem oberflächlichen Wasserfilm bei Annäherung eines Hindernisses und
- Fig. 6: einen Einklemmsensor ähnlich Fig. 2 aus einem flexiblen Trägermaterial, der sich im Wesentlichen in eine Längsrichtung erstreckt.

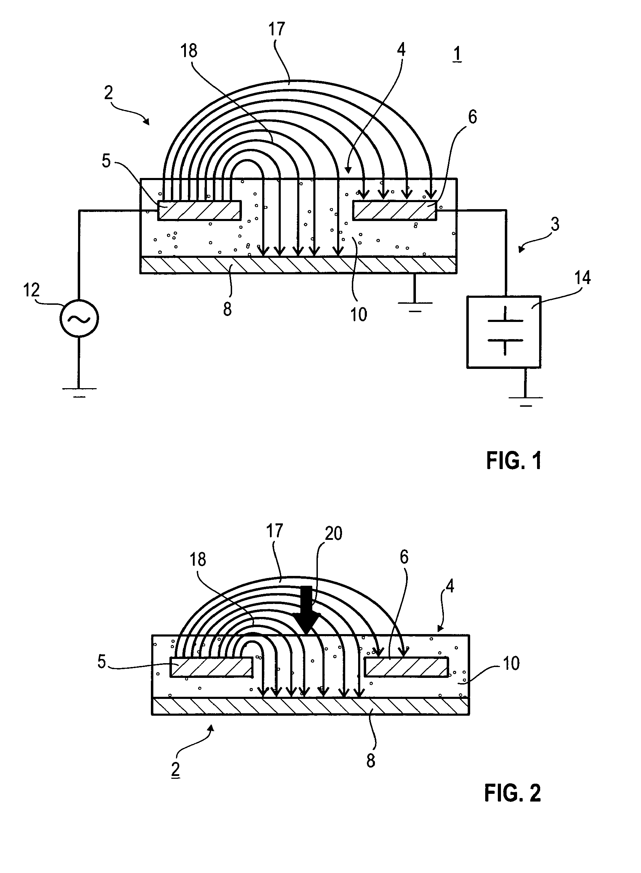

In Fig. 1 ist schematisch eine Sensoreinrichtung 1 dargestellt, die einen kapazitiven Einklemmsensor 2 sowie eine Messeinrichtung 3 zur Erfassung einer Messkapazität umfasst. Der kapazitive Einklemmsensor 2 ist in einem Querschnitt dargestellt.

Man erkennt den Sensorkörper 4, in dessen Innerem eine erste flächige Messelektrode 5 und eine zweite flächige Messelektrode 6 angeordnet sind. Die beiden Messelektroden 5, 6 sind dabei gegenüber einer flächigen Grundelektrode 8 in einem elastischen und elektrisch isolierenden Sensormaterial 10 angeordnet. Als ein solches Sensormaterial 10 kann beispielsweise ein Elastomerkunststoff oder ein Gummi eingesetzt sein. Insbesondere kann ein Moosgummi, d. h. ein elastischer Schaumstoff mit relativ geringer Porengröße, oder ein EPDM, d. h. ein Ethylen-Propylen-Dien-Kautschuk, eingesetzt sein. Die Grundelektrode 8 ist hier nicht Teil des Sensorkörpers 4. Sie ist vielmehr Teil der geerdeten Karosserie eines Kraftfahrzeugs, insbesondere eine Schließkante eines Stellelements wie einer verstellbaren Seitenscheibe

Die Messelektronik 3 umfasst eine Wechselstromquelle 12 sowie eine Auswerteschaltung 14 zur Erfassung der zwischen den beiden Messelektroden 5 und 6 gebildeten Messkapazität. Zur Erfassung der Messkapazität wird über die Wechselstromquelle 12 gegenüber dem Grundpotenzial wie Masse die erste Messelektrode 5 mit einer Wechselspannung beaufschlagt. Zur Erfassung der Messkapazität umfasst die Auswerteschaltung 14 bespielsweise eine geeignete Messbrücke zwischen der zweiten Messelektrode 6 und dem Grundpotenzial. Die Messkapazität kann dabei sowohl aus der Phasenlage als auch aus der Amplitude eines über die Messbrücke abgegriffenen Spannungswertes detektiert werden. Eine Änderung der Messkapazität kann insbesondere auch über ein Differenzsignal der erfassten Phasen oder Amplituden gegenüber den entsprechenden Werten einer Vergleichsmessbrücke mit vorbestimmter Kapazität ermittelt werden.

Man erkennt weiter in Figur 1, dass sich in Folge der Beaufschlagung der ersten Messelektrode 5 mit einem Wechselspannungssignal gegenüber dem Grundpotenzial ein äußeres elektrisches Feld 17 gegenüber der zweiten Messelektrode 6 ausbildet. Ebenso bildet sich ein direktes elektrisches Feld 18 zwischen der ersten Messelektrode 5 und der Grundelektrode 8 aus, die auf Grundpotenzial bzw. Masse liegt. Die Geometrie und Anordnung der Messelektroden 5, 6 im Sesnorkörper 4 ist dabei derart gewählt, dass sich das erzeugte äußere elektrische Feld 17 in einen Gefährdungsbereich hinein erstreckt, in welchem ein Hindernis berührungslos detektiert werden soll.

Dringt ein Hindernis aus der Ferne in das äußere elektrische Feld 17 des Einklemmsensors 2 ein, so wird sich die über die Auswerteschaltung 14 erfasste Messkapazität ändern. Insbesondere beruht eine derartige Änderung der Messkapazität darauf, dass sich bei einem Masseschluss des Hindernisses die Ladungsverteilung auf den Messelektroden 5, 6 verändert.

In Figur 2 ist der Einklemmsensor 2 gemäß Fig. 1 bei einer äußeren Krafteinwirkung dargestellt. Eine äußere Kraft 20 wirkt beispielsweise auf den Einklemmsensor 2, wenn sich ein Hindernis zwischen dem Stellelement und der Schließkante befindet, und das angetriebene Stellement das Hindernis gegen den Sensorkörper 4 des Einklemmsensors 2 presst.

Eine derartige Kraft 20 führt zu einer Stauchung des elastischen Sensormaterials 10 in Richtung der Kraft 20. Hierdurch verringert sich wie dargestellt der Abstand zwischen den Messelektroden 5 und 6 gegenüber der Grundelektrode 8. Durch die Annäherung der Grundelektrode 8, die sich auf Grundpotenzial bzw. Masse befindet, ändert sich die Ladungsverteilung auf den beiden Messelektroden 5 und 6. Diese Änderung der Ladungsverteilung kann auch dadurch beschrieben werden, dass sich als Folge der angenäherten Grundelektrode 8 das direkte elektrische Feld 18 zwischen der ersten Messelektrode 5 und der Grundelektrode 8 verstärkt. Mit anderen Worten werden Feldlinien aus dem äußeren elektrischen Feld 17 abgezogen. Die Kopplung der beiden Messelektroden 5 und 6 verringert sich; bei gleicher Spannung wird der Kondensator aus erster und zweiter Messelektrode weniger Ladung speichern. Als Folge nimmt die Messkapazität gegenüber dem entspannten Zustand des Einklemmsensors 2 ab.

Der gezeigte Einklemmsensor 2 ist somit in der Lage, die Einwirkung einer äußeren Kraft 20 ebenfalls über eine Änderung der Messkapazität zu erfassen. Sowohl für die berührungslose als auch für die taktile Detektion eines Hindernisses oder eines Einklemmfalles genügt eine Messelektronik 3 zur Erfassung der Messkapazität.

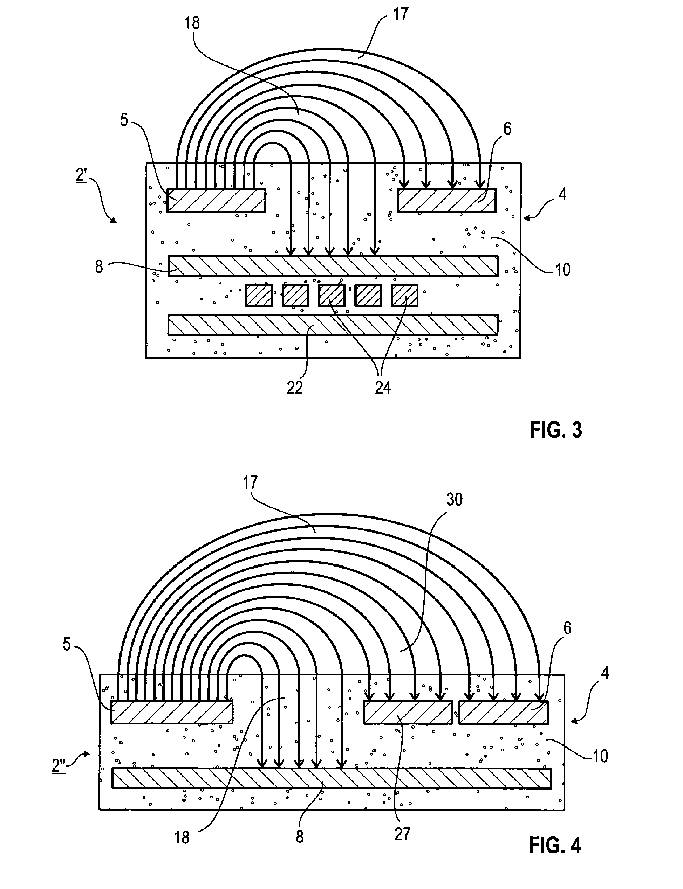

In Fig. 3 ist wiederum in einem Querschnitt ein modifizierter Einklemmsensor 2' dargestellt. Man erkennt den Sensorkörper 4, der in einem elastischen Sensormaterial 10 eingebettete Messelektroden 5 und 6 umfasst. In einer Ebene gegenüber den Messelektroden 5 und 6 ist nun, ebenfalls in den Sensorkörper 4 eingebettet, die Grundelektrode 8 angeordnet, die in Projektion mit ihrer Fläche die Flächen der Messelektrode 5 und 6 überstreicht. Ferner ist in dem Sensorkörper 4 eine zweite flächig ausgestaltete Grundelektrode 22 angeordnet.

In dem dargestellten Einklemmsensor 2' sind die Messelektroden 5 und 6 entlang des Sensorkörpers 4, d. h. in die Blattebene hinein, in eine Anzahl von Einzelelektroden separiert. Jede dieser Einzelelektroden verfügt über eine Zuleitung 24. Die einzelnen Zuleitungen 24 sind abgeschirmt zwischen der ersten und der zweiten Grundelektrode 8 und 22 angeordnet.

Die Funktionsweise des dargestellten Einklemmsensors 2' hinsichtlich der Detektion eines Einklemmfalles entspricht der des Einklemmsensors 2 gemäß Fig. 2. Allerdings ermöglicht die separate Ansteuerung der Einzelelektroden über die verschiedenen Zuleitungen 24 eine räumliche Auflösung der detektierten Einklemmflälle. Die Messelektronik 3 kann hierbei so ausgestaltet sein, dass die Messkapazitäten der Einzelelektroden zueinander entweder seriell oder parallel ausgewertet werden.

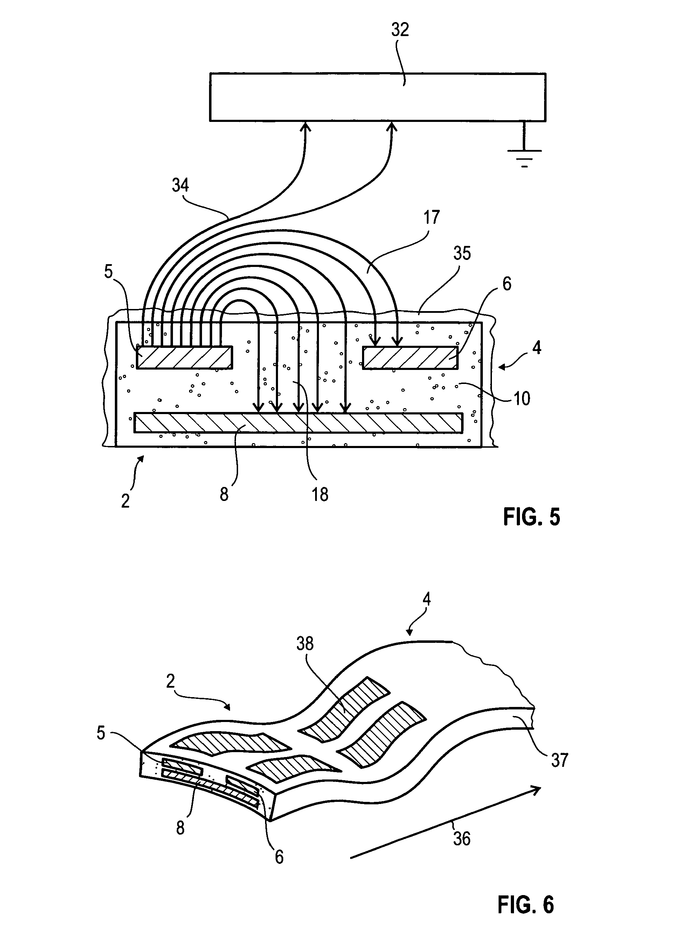

Der grundlegende Aufbau des Einklemmsensors 2' gemäß Fig. 3 wird insbesondere aus Fig. 6 ersichtlich. Wie der dort schematisch gezeichnete Einklemmsensor 2 erstreckt sich auch der Einklemmsensor 2' gemäß Fig. 3 im Wesentlichen entlang einer Längsrichtung 36, wobei das Sensormaterial 10 insgesamt einen flexiblen Träger bildet, in dem die einzelnen Elektroden 5, 6, 8, 22, 24 eingebettet sind.

Alternativ zu einem einheitlichen Aufbau mit einem einzigen elastischen und flexiblen Sensormaterial 10 ist es auch möglich, eine Zwischenlage aus einem höher elastischen Material lediglich zwischen den Messelektroden 5 und 6 sowie der Grundelektrode 8 vorzusehen, und als restliches flexibles Trägermaterial ein Material geringerer Elastizität vorzusehen.

In Fig. 4 ist in einem Querschnitt ein weiterer Einklemmsensor 2" dargestellt. Man erkennt, dass der Einklemmsensor 2" neben der Grundelektrode 8, der ersten Messelektrode 5 und der zweiten Messelektrode 6 nun eine dritte, in einer Ebene zwischen der ersten und der zweiten Messelektrode 5 bzw. 6 angeordnete Messelektrode 27 umfasst. Die zweite Messelektrode 6 ist in einem Randbereich des Sensorkörpers 10 angeordnet. Die erste, zweite und dritte Messelektrode 5, 6 bzw. 27 sind über das elastische Sensormaterial 10 gegenüber der Grundelektrode 8 elastisch gelagert.

Für die Ansteuerung des in Fig. 4 dargestellten Einklemmsensors 2" wird die erste Messelektrode 5 - wie in Fig. 1 dargestellt - gegenüber dem Grundpotenzial mit einer Wechselspannung beaufschlagt, während die zweite und die dritte Messelektrode 6 bzw. 27 wie die Grundelektrode 8 über eine definierte Impedanz mit dem Grundpotenzial verbunden sind. Es entsteht ein äußeres elektrisches Feld 17 zwischen der ersten Messelektrode 5 und der zweiten Messelektrode 6. Ebenfalls bildet sich zwischen der ersten Messelektrode 5 und der Grundelektrode 8 ein inneres elektrisches Feld 18 aus. Des Weiteren entsteht aufgrund der Potenzialdifferenz zwischen der ersten Messelektrode 5 und der dritten Messelektrode 27 ein zweites äußeres elektrisches Feld 30.

Man erkennt, dass sich das erste äußere elektrische Feld 17 auf Grund der größeren Distanz der zweiten Messelektrode 6 gegenüber der ersten Messelektrode 5 weiter in den Raum erstreckt als das zweite äußere elektrische Feld 17 zwischen der ersten Messelektrode 5 und der näher liegenden dritten Messelektrode 27.

Für die Detektion eines Einklemmfalles kann nun eine Messkapazität zwischen der ersten Messelektrode 5 und einer der beiden weiteren Messelektroden 6 oder 27 ausgewertet werden. In diesem Fall verhält sich der in Figur 3 dargestellte Einklemmsensor 2" analog zu dem in Fig. 1 oder 2 gezeigten Einklemmsensor 2.

Es ist aber genauso gut möglich, mit dem Einklemmsensor 2" die Differenz zwischen den beiden Messkapazitäten zu ermitteln, die zwischen der ersten Messelektrode 5 und der zweiten Messelektrode 6 bzw. zwischen der ersten Messelektrode 5 und der dritten Messelektrode 27 gebildet sind. Durch eine solche Detektion wird es vorteilhafterweise möglich, eine oberflächliche Ablagerung auf dem Sensorkörper 4 und die hieraus resultierenden Änderungen in den Messkapazitäten von einem tatsächlichen Einklemmfall zu unterscheiden. Während nämlich eine oberflächliche Ablagerung auf dem Sensorkörper 4 zu einer etwa gleichen Änderung in den beiden betrachteten Messkapazitäten führt, ist dies weder bei einer Annäherung des Hindernisses aus dem Fernfeld noch bei einer direkten Krafteinwirkung auf den Sensorkörper 4 der Fall.

Eine Annäherung eines Hindernisses aus dem Fernfeld führt maßgeblich zu einer Beeinflussung des ersten äußeren elektrischen Feldes 17. Eine aus einer Krafteinwirkung auf den Sensorkörper 4 resultierende Annäherung der Messelektroden 5, 6 und 27 gegenüber der Grundelektrode 8 führt maßgeblich zu einer Beeinflussung des zweiten äußeren elektrischen Felds 30. Wird demnach die Drift der beiden Messkapazitäten zueinander beobachtet, so kann sowohl ein berührungslos als auch ein direkt durch Krafteinwirkung gemessener Einklemmfall sicher von dem Fall einer oberflächlichen Ablagerung unterschieden werden.

Idealerweise sind die Dimensionen und die Anordnung der Messelektroden 5, 6 und 27 so gewählt, dass in einem Grundzustand die beiden Messkapazitäten zwischen der ersten Messelektrode 5 und der zweiten Messelektrode 6 bzw. zwischen der ersten Messelektrode 5 und der dritten Messelekrtrode 27 in etwa gleich groß sind. Eine oberflächliche Ablagerung auf dem Sensorkörper 4 führt dann zu keiner Drift zwischen den Messkapazitäten. Ein berührungslos und ein aktiv durch Berührung detektiertes Hindernis führt dagegen zu einer messbaren Drift der Messkapazitäten und ist als ein Einklemmfall detektierbar.

In Fig. 5 ist wiederum in einem Querschnitt der Einklemmsensor 2 gemäß Fig. 1 nochmals dargestellt, wobei sich nun auf der Oberfläche des Sensorkörpers 4 eine Wasserablagerung 35 befindet. Dabei wirkt die Wasserablagerung 35 wie das Einbringen eines Dielektrikums in das Feld zwischen der ersten Messelektrode 5 und der zweiten Messelektrode 6. Da Wasser eine größere Dielektrizitätszahl als Luft hat, wird sich hierdurch die Messkapazität vergrößern.

Nähert sich aus der Ferne dem äußeren elektrischen Feld 17 ein Hindernis wie beispielsweise eine menschliche Hand 32, die über die Hautoberfläche einen Masseschluss zeigt, so schwächt sich hierdurch die Kopplung zwischen der ersten Messelektrode 5 und der zweiten Messelektrode 6. Die auf dem durch die Messelektroden 5 und 6 gebildeten Kondensator speicherbare Ladung wird geringer bzw. werden Feldlinien aus dem äußeren elektrischen Feld 17 abgezogen. Letzteres ist durch die eingezeichneten Feldlinien 34 veranschaulicht, die nun von der ersten Messelektrode 5 zur der Hand 32 führen. Als Folge schwächt sich die Messkapazität zwischen der ersten Messelektrode 5 und der zweiten Messelektrode 6 ab.

Es wird deutlich, dass über die Messung der differenziellen Messkapazität zwischen der ersten Messlelektrode 5 und der zweiten Messelektrode 6 eine Unterscheidung zwischen einem sich aus der Ferne nähernden Hindernis und einer oberflächlichen Ablagerung möglich ist. Im ersten Fall schwächt sich die Messkapazität ab. Im zweiten Fall erhöht sich die Messkapazität in Folge des eingebrachten Dielektrikums. Dringt die menschliche Hand 32 schließlich in das Nahfeld des Einklemmsensors 2 ein, so kann gegebenfalls der Dielektizitätseffekt den des Masseschlusses überwiegen. Auch in diesem Fall ist jedoch eine klare Unterscheidung zwischen einem Hindernis und einer oberflächlichen Ablagerung möglich. Denn bei einem sich aus der Ferne nähernden Hindernis ist einer zunehmenden Messkapazität stets eine Phase einer sich verringernden Messkapazität vorgeschaltet. Im Falle einer oberflächlichen Beaufschlagung des Sensorkörpers 4 mit Wasser oder Schmutz wird sich die Messkapazität ohne eine vorherige Abnahme vergrößern. Auch weist eine Änderung der Messkapazität aufgrund eines Hindernisses eine eher kurze Zeitkonstante auf, während eine Änderung der Messkapazität aufgrund einer oberflächlichen Beaufschlagung eine größere Zeitkonstante zeigt.

In Fig. 6 ist schematisch in einer dreidimensionalen Darstellung der Aufbau eines Einklemmsensors 2 ähnlich Fig. 1 gezeigt. Man erkennt nun, dass sich der Sensorkörper 4 im Wesentlichen entlang einer Längsrichtung 36 erstreckt. Dabei ist der Einklemmsensor 2 bzw. der Sensorkörper 4 aus einem flexiblen Trägermaterial 37 gebildet. In dieses Trägermaterial 37 sind die als Einzelelektroden 38 ausgebildeten Messelektroden 5 bzw. 6 eingebettet. Am im vorderen Teil ersichtlichen Querschnitt ist die Lage der Messelektroden 5 und 6 gegenüber der Grundelektrode 8 erkennbar. Die einzelnen Zuleitungen zu den Einzelelektroden 38 sind aus Gründen der Übersichtlichkeit nicht dargestellt.

Bezugszeichenliste
- 1: Sensoreinrichtung
- 2: Einklemmsensor (2,2',2")
- 3: Messelektronik
- 4: Sensorkörper
- 5: erste Messelektrode
- 6: zweite Messelektrode
- 8: Grundelektrode
- 10: Sensormaterial
- 12: Wechselstromquelle
- 14: Auswerteschaltung
- 17: äußeres elektrisches Feld
- 18: direktes elektrisches Feld
- 20: Kraft
- 22: zweite Grundelektrode
- 24: Zuleitungen
- 27: dritte Messelektrode
- 30: zweites äußeres elektrisches Feld
- 32: Hand
- 34: Feldlinien
- 35: Wasserablagerung
- 36: Längsrichtung
- 37: Trägermaterial
- 38: Einzelelektroden

## Patentansprüche

1. Einklemmsensor (2,2',2"), insbesondere zum Erkennen eines Hindernisses im Weg eines Stellelements eines Kraftfahrzeugs, mit einer ersten Messelektrode (5) und mit einer von der ersten Messelektrode (5) beabstandeten, elektrisch getrennten zweiten Messelektrode (6), wobei die erste Messelektrode (6) zur Erzeugung eines äußeren elektrischen Felds (17) gegenüber der zweiten Messelektrode (6) ausgebildet ist,
**dadurch gekennzeichnet,**
**dass** die erste und zweite Messelektrode (5,6) gegenüber einer elektrisch getrennten Grundelektrode (8) elastisch gelagert sind.

2. Einklemmsensor (2,2',2") nach Anspruch 1,
**dadurch gekennzeichnet,**
**dass** die erste und die zweite Messelektrode (5,6) auf einer ersten Ebene angeordnet sind, die von einer zweiten Ebene, in der die Grundelektrode (8) angeordnet ist, beabstandet ist.

3. Einklemmsensor (2,2',2") nach Anspruch 1 oder 2,
**dadurch gekennzeichnet,**
**dass** zur elastischen Lagerung der beiden Messelektroden (5,6) gegenüber der Grundelektrode (8) eine Zwischenlage aus einem elastischen und elektrisch isolierenden Material (10) vorgesehen ist.

4. Einklemmsensor (2,2',2") nach einem der vorhergehenden Ansprüche,
**dadurch gekennzeichnet,**
**dass** die Grundelektrode (8) ein Sensorbestandteil ist.

5. Einklemmsensor (2,2',2") nach einem der vorhergehenden Ansprüche,
**dadurch gekennzeichnet,**
**dass** die Messelektroden (5,6) jeweils in einem Randbereich angeordnet sind.

6. Einklemmsensor (2,2',2") nach einem der vorhergehenden Ansprüche,
**dadurch gekennzeichnet,**
**dass** die Elektroden (5,6,8) jeweils flächig ausgebildet sind.

7. Einklemmsensor (2,2',2") nach Anspruch 6,
**dadurch gekennzeichnet,**
**dass** die Fläche der Grundelektrode (8) in Projektion die Flächen beider Messelektroden (5,6) überstreicht.

8. Einklemmsensor (2,2',2") nach einem der vorhergehenden Ansprüche,
**dadurch gekennzeichnet,**
**dass** eine dritte, von der ersten und der zweiten Messelektrode (5,6) elektrisch getrennte Messelektrode (27) vorgesehen ist, die zur zweiten Messelektrode (6) benachbart ist, und dass die Messelektroden (5,6) zur Ausbildung eines ersten äußeren elektrischen Feldes (17) zwischen der ersten und der zweiten Messelektrode (5 bzw. 6) und eines zweiten äußeren elektrischen Feldes (30) zwischen der ersten und der dritten Messelektrode (5 bzw. 27) ausgebildet sind, wobei das zweite äußere elektrische Feld (30) eine geringere Reichweite aufweist als das erste äußere elektrische Feld (17).

9. Einklemmsensor (2,2',2") nach einem der vorhergehenden Ansprüche,
**dadurch gekennzeichnet,**
**dass** die Elektroden (5,6,8) und die Zwischenlage in einem Sensorkörper (4) aus einem flexiblen Trägermaterial (37) angeordnet sind.

10. Einklemmsensor (2,2',2") nach Anspruch 9,
**dadurch gekennzeichnet,**
**dass** sich der Sensorkörper (4) im Wesentlichen entlang einer Längsrichtung (36) erstreckt, und dass die erste Messelektrode (5) entlang der Längsrichtung (36) jeweils in einzeln ansteuerbare Einzelelektroden (38) unterteilt ist.

11. Einklemmsensor (2,2,',2") nach Anspruch 10,
**dadurch gekennzeichnet,**
**dass** alle Messelektroden (5,6,8) entlang der Längsrichtung (36) in einzeln ansteuerbare Einelelektroden (38) unterteilt sind.

12. Sensoreinrichtung (1) mit einem Einklemmsensor (2,2',2") nach einem der vorhergehenden Ansprüche und mit einer Messelektronik (3) zur Detektion einer Messkapazität zwischen der ersten und der zweiten Messelektrode (5 bzw. 6).

13. Sensoreinrichtung (1) nach Anspruch 12,
**dadurch gekennzeichnet,**
**dass** eine dritte, von der ersten und der zweiten Messelektrode (5,6) elektrische getrennte Messelektrode (27) vorgesehen ist, die zur zweiten Messelektrode (6) benachbart ist, dass die Messelektroden (5,6) zur Ausbildung eines ersten äußeren elektrischen Feldes (17) zwischen der ersten und der zweiten Messelektrode (5 bzw. 6) und eines zweiten äußeren elektrischen Feldes (30) zwischen der ersten und der dritten Messelektrode (5 bzw. 27) ausgebildet sind, wobei das zweite äußere elektrische Feld (30) eine geringere Reichweite aufweist als das erste äußere elektrische Feld (17), und dass die Messelektronik (3) dafür ausgelegt ist, eine Drift der Kapazität zwischen der ersten und der zweiten Messelektrode (5 bzw. 6) gegenüber einer Kapazität zwischen der ersten und der dritten Messelektrode (5 bzw. 27) zu erfassen.

14. Sensoreinrichtung (1) nach Anspruch 12 oder 13,
**dadurch gekennzeichnet,**
**dass** die Elektroden (5,6,8) und die Zwischenlage in einem Sensorkörper (4) aus einem flexiblen Trägermaterial (37) angeordnet sind, dass sich der Sensorkörper (4) im Wesentlichen entlang einer Längsrichtung (36) erstreckt, dass die erste Messelektrode (6) entlang der Längsrichtung (36) jeweils in einzeln ansteuerbare Einzelelektroden (38) unterteilt ist, und dass die Messelektronik (3) dafür ausgelegt ist, die Einzelektroden (38) separat anzusteuern.

15. Sensoreinrichtung nach Anspruch 14,
**dadurch gekennzeichnet,**
**dass** alle Messelektroden (5,6,8) entlang der Längsrichtung (36) in Einzelelektroden (38) unterteilt sind.
